# EUROPÄISCHE PATENTSCHRIFT

(11) **EP 1 572 501 B1**
(45) Veröffentlichungstag und Bekanntmachung des Hinweises auf die Patenterteilung: **07.07.2010**
(21) Anmeldenummer: 03757689.9
(22) Anmeldetag: 08.10.2003
(51) Int. Cl.: B60R 16/02, B60T 8/32, H05K 7/02, H05K 7/14, H05K 5/00

(54) **ELEKTROMECHANISCHE BAUGRUPPE**
ELECTROMECHANICAL SUB-ASSEMBLY
ENSEMBLE ELECTROMECANIQUE

(30) Priorität: 20.12.2002 DE 10259850
(43) Veröffentlichungstag der Anmeldung: 14.09.2005
(73) Patentinhaber: Conti Temic microelectronic GmbH, 90411 Nürnberg (DE)
(72) Erfinder: PIRNER, Hermann, 92278 Illschwang (DE); WEBER, Robert, 91301 Forchheim (DE); URBANEK, Thomas, 90425 Nürnberg (DE)
(86) Internationale Anmeldenummer: PCT/DE2003/003326
(87) Internationale Veröffentlichungsnummer: WO 2004/060723

(56) Entgegenhaltungen:
- EP-A- 1 241 386
- DE-A- 4 340 280
- FR-A- 2 741 118
- US-A- 5 941 282

## Beschreibung

Die Erfindung betrifft eine elektromechanische Baugruppe aus elektronischen und mechanischen Komponenten gemäß dem Oberbegriff des Patentanspruchs.

Die Druckschrift DE 43 40 280 A1 offenbart einen Bauteilesatz für ein Gehäuse zum Aufnehmen einer Schaltungsträgerplatte mit elektronischen Bauelementen. Das Gehäuse umfasst einen Rahmen, in welchen elektrische Leitungen eingebettet sind, die von innen nach außen durch den Rahmen hindurchführen. Auf der Unterseite des Rahmens ist ein Boden, auf der Oberseite des Rahmens ein Deckel anzufügen. Die Unterseite und die Oberseite des Rahmens sind einander ergänzend so profiliert, dass zwei gleiche Rahmen, die jeweils eine Schaltungsträgerplatte aufnehmen mit Unterseite und Oberseite spielfrei zusammengefügt werden können.

Die EP 1 241 386 A1 offenbart eine als elektromechanische Baugruppe ausgeführte Steuereinrichtung für Druckmittel mit einem ersten Gehäuseteil, in dem eine steuerbare Ventileinrichtung und eine erste elektrische Einrichtung angeordnet ist, und mit einem zweiten Gehäuseteil, der als Deckel dient mit einer zweiten elektrischen Einrichtung zum Steuern der Ventileinrichtung, wobei das erste und das zweite Gehäuseteil miteinander verbindbar sind. An der zweiten elektrischen Einrichtung ist ein als Negativteil ausgebildetes Kontaktelement und an der ersten elektrischen Einrichtung ist ein als Positivteil ausgebildetes Kontaktelement angeordnet. Nach dem Zusammenfügen der beiden Gehäuseteile bilden das Negativteil und das Positivteil zusammen eine elektrische Steckverbindung.

Die US 5,941,282 offenbart eine elektromagnetische Ventileinheit mit einem Gehäuse, in dem eine erste und eine zweite Kammer definiert sind. Die Kammern sind durch ein Wandelement getrennt, das zumindest ein Verbindungsloch aufweist. Die elektromagnetische Ventileinheit umfasst ferner eine Vielzahl elektromagnetischer Ventile, die jeweils zumindest einen elektrischen Anschluss haben. Die elektromagnetische Ventileinheit umfasst ferner eine Leiterplatte, auf der ein elektronisches Regelelement montiert ist, wobei die Leiterplatte in der zweiten Kammer des Gehäuses montiert ist. Die elektromagnetische Ventileinheit umfasst ferner ein leitendes Element, dessen einer Endabschnitt mit jedem Anschluss des elektromagnetischen Ventils verbunden ist und dessen anderer Endabschnitt mit der Leiterplatte durch das Verbindungsloch des Wandelements verbunden ist. Auf der Oberseite des Gehäuses ist ein Deckel angeordnet. Die Ventile sind auf einem Ventilkörper angeordnet

Baugruppen, die als Zwischenprodukte hergestellt und vertrieben werden, werden in der Regel mit für einen jeweiligen Kunden spezifischen Merkmalen ausgestattet. Bei Baugruppen mit elektronischen Komponenten sind dies beispielsweise die elektrischen Anschlussvorrichtung der elektronischen Komponente, über welche die elektronische Komponente mittels eines kundenspezifischen Anschlusselementes beispielsweise an eine Spannungsversorgung oder an ein der elektronischen Baugruppe zugeordnetes Steuergerät angeschlossen wird.

Dabei führt die Anpassung der Baugruppe an kundenspezifische Merkmale bei der Herstellung dazu, dass mehrere sich beispielsweise in diesen elektrischen Anschlussvorrichtungen unterscheidende Gehäuse zur Aufnahme der elektU-ronischen Komponente hergestellt werden müssen. Dadurch reduziert sich die Stückzahl der identisch herzustellenden Gehäuse, wodurch die Herstellungskosten für die Baugruppe stark zunehmen.

Der Erfindung liegt die Aufgabe zugrunde, eine elektromechanische Baugruppe anzugeben, bei der das Gehäuse in Bezug auf seine internen und externen Kontaktanschlüsse kompatibel zu verschiedenen Gehäusevarianten ausgebildet ist und trotzdem kostengünstig herstellbar ist. Zudem sollen die zur elektromechanische Baugruppe gehörenden Komponenten und Teilkomponenten möglichst kompakt zusämmenfassbar sein.

Erfindungsgemäß wird diese Aufgabe durch eine elektromechanische Baugruppe mit den Merkmalen des Patentanspruchs 1 gelöst.

Demgemäß ist eine elektromechanische Baugruppe vorgesehen, mit einem Steuermodul mit ersten Kontakten, einem Mechanikmodul mit zweiten Kontakten, einem Trägermodul zur Befestigung des Steuermoduls sowie des Mechanikmoduls, wobei das Trägermodul erste Anschlüsse zur Kontaktierung der ersten Kontakte, zweite Anschlüsse zur Kontaktierung der zweiten Kontakte und mindestens eine Anschlussvorrichtung zur Kontaktierung der elektromechanischen Baugruppe aufweist.

Die so ausgebildete elektromechanische Baugruppe.kann kostengünstig hergestellt werden, da das die Gehäuse bildende Trägermodul einfach mit unterschiedlichen Anschlüsse hergestellt werden kann. Dabei sind das Steuermodul, das Mechanikmodul und das Trägermodul kompakt zusammen gefasst, wodurch beispielsweise Wartungsarbeiten leicht durchzuführen sind.

Vorteilhafte Ausgestaltungen und Weiterbildungen sind den Unteransprüchen sowie der Beschreibung unter Bezugnahme auf die Zeichnung entnehmbar.

In einer Weiterbildung der Erfindung ist vorgesehen, dass das Trägermodul einen Körper bildet, in dem Stanzgitter eingearbeitet sind. Diese Stanzgitter bilden die elektrische Verbindungen innerhalb der elektromechanischen Baugruppe, also zwischen der mindestens einen Anschlussvorrichtung, den ersten Anschlüssen und den zweiten Anschlüssen. Dabei ist das Trägermodul aus einem elektrisch nicht leitfähigen Material gefertigt.

In einer weiteren Weiterbildung der Erfindung ist vorgesehen, dass die aus dem Steuermodul, dem Mechanikmodul und dem Trägermodul zusammengesetzte elektromechanische Baugruppe eine etwa quaderförmige Bauform aufweist. In den Ecken der elektromechanische Baugruppe sind vier Aussparungen für Verbindungselemente, beispielsweise Schrauben, eingebracht. Zwei der Aussparungen sind als Verschraubungsbohrung zum miteinander Verbinden des Steuermoduls, des Mechanikmoduls und des Trägermoduls ausgebildet. Die anderen zwei Aussparungen sind als Befestigungsbohrung zum Befestigen der elektromechanischen Baugruppe, beispielsweise an einem Lastkraftwagen, ausgebildet.

Das Steuermodul besteht aus einem wärmeleitfähigen Metall, auf dem eine die ersten Kontakte aufweisende Schaltungsanordnung aufgebracht ist.

Das Steuermodul ist so ausgebildet, dass es den Deckel der elektromechanischen Baugruppe bildet.

In einer Weiterbildung der Erfindung ist vorgesehen, dass in dem Mechanikmodul Aktoren und Sensoren angeordnet sind, die einen Regelkreis bilden.

Die elektronische Steuerung des Regelkreises ist vorteilhafterweise in der Schaltungsanordnung des Steuermoduls angeordnet.

In einer Weiterbildung der Erfindung ist vorgesehen, dass das Steuermodul, das Mechanikmodul und das Trägermodul im zusammengebauten Zustand ein nach außen wasserdichtes Gehäuse bilden.

In einer typischen Ausgestaltung der Erfindung bildet mindestens eine der Anschlussvorrichtungen einen externen Anschluss der elektromechanischen Baugruppe.

In einer typischen Ausgestaltung der Erfindung bilden die Anschlüsse und Kontakte jeweils eine Anschlussleiste bzw. eine Kontaktleiste, wobei eine jeweilige Kontaktleiste mit der ihr zugeordneten Anschlussleiste nach dem Schlüssel-Schloss-Prinzip zusammensteckbar sind.

Die Erfindung wird nachfolgend anhand der in den Figuren der Zeichnung angegebenen Ausführungsbeispiele näher erläutert. Es zeigt dabei:
- Figur 1: eine Darstellung der zusammengesetzten, aus Steuermodul, Mechanikmodul und Trägermodul bestehenden elektromechanischen Baugruppe,
- Figur 2: eine Darstellung der einzelnen, aus Steuermo- dul, Mechanikmodul und Trägermodul bestehen- den elektromechanischen Baugruppe.

In allen Figuren der Zeichnung sind gleiche bzw. funktionsgleiche Elemente und Teile - sofern nichts anderes angegeben ist - mit gleichen Bezugszeichen versehen worden.

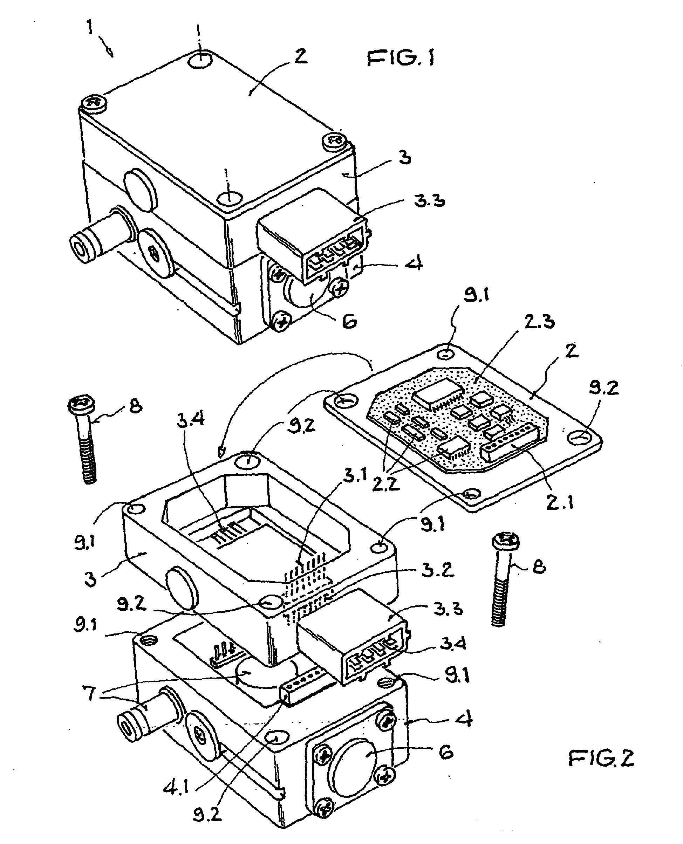

In der Figur 1 ist die fertig montierte elektromechanische Baugruppe 1 dargestellt, die aus einem Steuermodul 2, einem Trägermodul 4 und einem Mechanikmodul 3 besteht. Die elektromechanische Baugruppe 1 dient zur Regelung des Druckes einer Pneumatischen Anlage eines Lastkraftwagens.

Bei dieser Ausführung sind in dem aus Aluminiumguss gefertigten Mechanikmodul 4 Sensoren enthalten, die den pneumatischen Druck in der Anlage messen. Zudem ist in dem Mechanikmodul ein Aktor 6 enthalten, der als Ventile ausgebildet ist, das ein Ablassen von Druckluft ermöglicht.

An dem Trägermodul 3 ist eine Anschlussvorrichtung 3.3 ausgebildet, über welche alle elektronischen Bestandteile der elektromechanischen Baugruppe an eine Spannungsversorgung angeschlossen sind, und über welche die elektromechanischen Baugruppe mit weiteren elektrischen Komponenten des Lastkraftwagens, beispielsweise einem Kompressor, verbunden ist. Das Trägermodul ist in einem elektrisch nicht leitfähigen Kunststoffspritzverfahren hergestellt worden. Die Anschlussvorrichtung 3.3 ist nach den Vorgaben des Herstellers des Lastkraftwagens ausgebildet.

In der Figur 2 sind die Bestandteile der elektromechanische Baugruppe dargestellt. Das Steuermodul 2, das Trägermodul 3 und das Mechanikmodul 4 sind durch Schrauben 8 miteinander verbunden, die an zwei gegenüberliegenden Ecken der im wesentlichen rechteckigen elektromechanische Baugruppe ausgebildet sind..Dazu sind in der elektromechanische Baugruppe zwei Verschraubungsbohrungen 9.1 kleineren Durchmessers eingebracht, wobei vorzugsweise in das Mechanikmodul Gewinde für die Schrauben 9 eingebracht sind. Die zwei verbleibenden Ecken der elektromechanische Baugruppe weisen Befestigungsbohrungen 9.2 mit einem größeren Durchmesser auf, die dem Befestigen der elektromechanische Baugruppe an dem Lastkraftwagen dienen.

Das Steuermodul 2 besteht im wesentlichen aus einer Aluminiumplatte, auf der auf einer Leiterplatte oder einem Keramikkörper 2.3 eine Schaltungsanordnung 2.2 aufgebracht ist. Diese Schaltung ist beispielsweise in SMD-Technik auf Leiterplattenbasis oder in Hybridtechnik aufgebracht worden. Die Schaltungsanordnung 2.2 umfasst den Regelkreis der pneumatischen Anlage, beispielsweise einen Proportionalregelkreis. Innerhalb dieses Regelkreises wird der Istwert des von dem Sensor 5 bestimmten pneumatischen Druckes mit einem beispielsweise vom Betriebszustand des Lastkraftwagens abhängigen Sollwert verglichen. Bei überschreiten des Sollwertes wird beispielsweise der als Ablassventil ausgebildete Aktor 6 geöffnet, beim Unterschreiten des Sollwertes wird der Kompressor des Lastkraftwagens aktiviert.

Die auf dem Keramikkörper 2.3 aufgebrachte Schaltungsanordnung 2.1 des Steuermoduls 2 umfasst eine erste Kontaktleiste 2.1, über welche die Schaltungsanordnung 2.1 an Masse- , Spannungs- und Signalleitungen angeschlossen ist.

An dem Mechanikmodul 4 ist eine zweite Kontaktleiste 4.1 ausgebildet, über welche die Aktoren 6 und Sensoren 5 an Masse- , Spannungs- und Signalleitungen angeschlossen sind.

Bei der Montage der elektromechanische Baugruppe wird die erste Kontaktleiste 2.1, des Steuermoduls 2 mit der ersten Anschlussleiste 3.1 des Trägermoduls 3 verbunden. Ebenso wird die zweite Kontaktleiste 4.1 des Mechanikmoduls 4 mit einer zweiten Anschlussleiste 3.2 des Trägermoduls verbunden. Die erste Anschlussleiste 3.1 und die zweite Anschlussleiste 3.2 sind mit einem im Trägermodul 3 eingegossenen Stanzgitter 3.4 verbunden, welches die Kontakte einer Anschlussvorrichtung 3.3 bildet. Die Anschlussvorrichtung 3.3 ist entsprechend den Spezifikationen des Herstellers des Lastkraftwagens ausgebildet, wobei auf die Anschlussvorrichtung 3.3 eine Steckvorrichtung aufgeschoben werden kann.

Zur Abdichtung der elektromechanischen Baugruppe (1) gegen das Eindringen von Wasser können beispielsweise in dem Trägermodul (3) auf den dem Steuermodul (2) und dem Mechanikmodul (4) zugewandten Seiten jeweils eine umlaufende Nut ausgebildet sein, in welche ein O-Ring eingesetzt wird.

Durch die Möglichkeit nur das Trägermodul 3 entsprechend dem Kundenwunsch anpassen zu müssen kann die elektromechanische Baugruppe kostengünstig hergestellt werden. Durch den modularen Aufbau, der in einfacher Weise zerlegt werden kann, sind Wartungsarbeiten an der elektromechanische Baugruppe leicht durchzuführen.

Zusammenfassend kann festgestellt werden, dass durch die wie beschrieben ausgestaltete elektronische Baugruppe auf sehr einfache jedoch nichts desto trotz sehr effektive Weise eine sehr hohes Maß an Kompatibilität bei unterschiedlichsten Baugruppenvarianten erzielbar ist, ohne dass auf die Möglichkeit einer kostengünstigen und einfachen Herstellung verzichtet werden muss.

Die vorliegende Erfindung wurde anhand der vorstehenden Beschreibung so dargestellt, um das Prinzip der Erfindung und dessen praktische Anwendung bestmöglichst zu erklären, jedoch lässt sich die Erfindung bei geeigneter Abwandlung selbstverständlich in mannigfaltigen anderen Ausführungsformen realisieren.

### Bezugszeichenliste

- 1: Elektromechanische Baugruppe

- 2: Steuermodul
- 2.1: erste Kontaktleiste
- 2.2: Schaltungsanordnung
- 2.3: Keramikkörper, Leiterplatte

- 3: Trägermodul
- 3.1: erste Anschlussleiste
- 3.2: zweite Anschlussleiste
- 3.3: Anschlussvorrichtung
- 3.4: Stanzgitter

- 4: Mechanikmodul
- 4.1: zweite Kontaktleiste

- 5: Sensoren
- 6: Aktoren
- 7: Pneumatischer Anschluss

- 8: Schrauben

- 9.1: Verschraubungsbohrung
- 9.2: Befestigungsbohrung

## Patentansprüche

1. Elektromechanische Baugruppe (1) mit einem Steuermodul (2) mit ersten Kontakten (2.1),einem Mechanikmodul (4) mit zweiten Kontakten (4.1),einem Trägermodul (3) zur Befestigung des Steuermoduls (2) sowie des Mechanikmoduls (4), wobei das Trägermodul (3) erste Anschlüsse (3.1) zur Kontaktierung der ersten Kontakte (2.1), zweite Anschlüsse (3.2) zur Kontaktierung der zweiten Kontakte (4.1) und mindestens eine Anschlussvorrichtung (3.3) zur Kontaktierung der elektromechanischen Baugruppe (1) aufweist, **dadurch gekennzeichnet, dass,** dass das Steuermodul (2) einen wärmeleitfähigen, metallhaltigen Werkstoff enthält, und dass auf diesem Werkstoff eine die ersten Kontakte (2.1) aufweisende Schaltungsanordnung (2.2) aufgebracht ist, und dass das Steuermodul (2) einen Deckel zur Abdeckung der elektromechanischen Baugruppe (1) ausbildet.

2. Elektromechanische Baugruppe nach Anspruch 1,
**dadurch gekennzeichnet,**
**dass** das Trägermodul (3) ein elektrisch isolierenden Werkstoff enthält.

3. Elektromechanische Baugruppe nach einem der vorstehenden Ansprüche,
**dadurch gekennzeichnet,**
**dass** das Trägermodul (3) Stanzgitter (3.4) zur elektrischen Verbindung der mindestens einen Anschlussvorrichtung (3.3), der ersten Anschlüsse (2.1) und der zweiten Anschlüsse (4.1) enthält.

4. Elektromechanische Baugruppe nach einem der vorstehenden Ansprüche,
**dadurch gekennzeichnet,**
**dass** die das Steuermodul (2), das Mechanikmodul (4) und das Trägermodul (3) enthaltende elektromechanische Baugruppe (1) eine mit Eckbereichen ausgestattete, etwa quaderförmige Bauform aufweist.

5. Elektromechanische Baugruppe nach Anspruch 4,
**dadurch gekennzeichnet,**
**dass** in den Eckbereichen der elektromechanische Baugruppe (1) zumindest vier Aussparungen eingebracht sind, wobei zwei Aussparungen als Verschraubungsbohrung (9.1) zum Verbinden des Steuermoduls (2), des Mechanikmoduls (4) und des Trägermoduls (3) ausgebildet sind und wobei zumindest zwei andere Aussparungen als Befestigungsbohrung (9.2) zum Befestigen der elektromechanischen Baugruppe (1) ausgebildet sind.

6. Elektromechanische Baugruppe nach einem der vorstehenden Ansprüche,
**dadurch gekennzeichnet,**
**dass** in dem Mechanikmodul (4) eine Vielzahl einen Regelkreis bildende Aktoren (6) und Sensoren (5) vorgesehen sind.

7. Elektromechanische Baugruppe nach Anspruch 6,
**dadurch gekennzeichnet,**
**dass** der Regelkreises in der Schaltungsanordnung (2.2) des Steuermoduls (2) angeordnet ist.

8. Elektromechanische Baugruppe nach einem der vorstehenden Ansprüche,
**dadurch gekennzeichnet,**
**dass** das Steuermodul (2), das Mechanikmodul (4) und das Trägermodul (3) im zusammengebauten Zustand ein nach außen wasserdichtes Gehäuse bilden.

9. Elektromechanische Baugruppe nach einem der vorstehenden Ansprüche,
**dadurch gekennzeichnet,**
**dass** mindestens eine der Anschlussvorrichtungen (3.3) einen externen Anschluss (3.3) der elektromechanischen Baugruppe (1) bildet.

10. Elektromechanische Baugruppe nach einem der vorstehenden Ansprüche,
**dadurch gekennzeichnet,**
**dass** die Anschlüsse (3.1, 3.2) und Kontakte (2.1, 4.1) jeweils eine Anschlussleiste (3.1, 3.2) bzw. eine Kontaktleiste (2.1, 4.1) bilden.

## Claims

1. An electro-mechanical assembly (1) with a control module (2) with first contacts (2.1), a mechanical module (4) with second contacts (4.1), a carrier module (3) for attaching the control module (2) and the mechanical module (4), wherein the carrier module (3) comprises first connections (3.1) for contacting the first contacts (2.1), second connections (3.2) for contacting the second contacts (4.1) and at least one connection device (3.3) for contacting the electro-mechanical assembly (1), **characterized in that** the control module (2) contains a heat conducting material containing metal, and that on said material, a circuit arrangement (2.2) which comprises the first contacts (2.1) is attached, and that the control module (2) forms a lid for covering the electro-mechanical assembly (1).

2. An electro-mechanical assembly according to claim 1,
**characterized in that**
the carrier module (3) contains an electrically insulating material.

3. An electro-mechanical assembly according to any one of the preceding claims,
**characterized in that**
the carrier module (3) contains punching scrap (3.4) for the electrical connection of the at least one connection device (3.3), the first connections (2.1) and the second connections (4.1).

4. An electro-mechanical assembly according to any one of the preceding claims,
**characterized in that**
the electro-mechanical assembly (1) which contains the control module (2), the mechanical module (4) and the carrier module (3) has a structure which is equipped with corner areas, and which is approximately cuboid.

5. An electro-mechanical assembly according to claim 4,
**characterized in that**
in the corner areas of the electro-mechanical assembly (1), at least four recesses are inserted, wherein two recesses are designed as a screw connection hole (9.1) for connecting the control module (2), the mechanical module (4) and the carrier module (3), and wherein at least two other recesses are designed as a fastening bore hole (9.2) for affixing the electro-mechanical assembly (1).

6. An electro-mechanical assembly according to any one of the preceding claims,
**characterized in that**
in the mechanical module (4), a plurality of actuators (6) and sensors (5) which form a control circuit are provided.

7. An electro-mechanical assembly according to claim 6,
**characterized in that**
the control circuit is arranged in the circuit arrangement (2.2) of the control module (2).

8. An electro-mechanical assembly according to any one of the preceding claims,
**characterized in that**
the control module (2), the mechanical module (4) and the carrier module (3) form when assembled a housing which is externally water-resistant.

9. An electro-mechanical assembly according to any one of the preceding claims,
**characterized in that**
at least one of the connection devices (3.3) forms an external connection (3.3) of the electro-mechanical assembly (1).

10. An electro-mechanical assembly according to any one of the preceding claims,
**characterized in that**
the connections (3.1, 3.2) and contacts (2.1, 4.1) respectively form a connection strip (3.1, 3.2) or a contact strip (2.1, 4.1).

## Revendications

1. Assemblage électromécanique (1) avec un module de commande (2) avec premiers contacts (2.1), un module mécanique (4) avec deuxièmes contacts (4.1), un module support (3) pour la fixation du module de commande (2) ainsi que du module mécanique (4), le module support (3) présentant des premiers connecteurs (3.1) pour la connexion des premiers contacts (2.1), des deuxièmes connecteurs (3.2) pour la connexion des deuxièmes contacts (4.1) et au moins un dispositif de connexion (3.3) pour la connexion de l'assemblage électromécanique (1),
**caractérisé en ce que**
le module de commande (2) contient un matériau conduisant la chaleur contenant du métal et **en ce que**, sur ce matériau, un agencement de circuit (2.2) présentant les premiers contacts (2.1) est disposé, et **en ce que** le module de commande (2) forme un couvercle pour couvrir l'assemblage électromécanique (1).

2. Assemblage électromécanique selon la revendication 1,
**caractérisé en ce que**
le module support (3) contient un matériau électriquement isolant.

3. Assemblage électromécanique selon l'une des revendications précédentes,
**caractérisé en ce que**
le module support (3) comprend des grilles perforées (3.4) pour la connexion électrique de l'au moins un dispositif de connexion (3.3), des premiers connecteurs (2.1) et des deuxièmes connecteurs (4.1).

4. Assemblage électromécanique selon l'une des revendications précédentes,
**caractérisé en ce que**
l'assemblage électromécanique (1) comprenant le module de commande (2), le module mécanique (4) et le module support (3) présente un type de construction muni de régions angulaires, par exemple un type de construction en parallélépipède rectangle.

5. Assemblage électromécanique selon la revendication 4,
**caractérisé en ce que**
dans les régions angulaires de l'assemblage électromécanique (1), au moins quatre évidements sont effectués, deux évidements étant formés comme trous de vissage (9.1) pour l'assemblage du module de commande (2), du module mécanique (4) et du module support (3), et au moins deux autres évidements étant formés comme trous de fixation (9.2) pour la fixation de l'assemblage électromécanique (1).

6. Assemblage électromécanique selon l'une des revendications précédentes,
**caractérisé en ce que**
dans le module mécanique (4), une multiplicité d'actionneurs (6) et de capteurs (5) formant une boucle de régulation est prévue.

7. Assemblage électromécanique selon la revendication 6,
**caractérisé en ce que**
la boucle de régulation est disposée dans l'agencement de circuit (2.2) du module de commande (2).

8. Assemblage électromécanique selon l'une des revendications précédentes,
**caractérisé en ce que**
le module de commande (2), le module mécanique (4) et le module support (3) forment un boîtier étanche vis-à-vis de l'extérieur en état assemblé.

9. Assemblage électromécanique selon l'une des revendications précédentes,
**caractérisé en ce que**
au moins un des dispositifs de connexion (3.3) forme une connexion externe (3.3) de l'assemblage électromécanique (1).

10. Assemblage électromécanique selon l'une des revendications précédentes,
**caractérisé en ce que**
les connexions (3.1, 3.2) et les contacts (2.1, 4.1) forment respectivement une barrette de connexion (3.1, 3.2) ou une barrette de contact (2.1, 4.1).
